# EUROPEAN PATENT SPECIFICATION

(11) **EP 1 118 085 B1**
(45) Date of publication and mention of the grant of the patent: **05.07.2006**
(21) Application number: 99929995.1
(22) Date of filing: 20.05.1999
(51) Int. Cl.: H01B 1/24, B32B 29/00

(54) **AN ELECTRICALLY CONDUCTIVE LAYER OF CELLULOSE FIBRES AND A COMPOSITE THEREOF**
EINE ELEKTRISCH LEITENDE SCHICHT AUS ZELLULOSE FASERN UND EIN KOMPOSIT DARAUS
COUCHE DE FIBRES CELLULOSIQUES ELECTRIQUEMENT CONDUCTRICE, ET COMPOSITE

(30) Priority: 28.05.1998 SE 9801928
(43) Date of publication of application: 25.07.2001
(73) Proprietor: Knauf Gips KG, 97346 Iphofen (DE)
(72) Inventor: MOLDAN, Dietrich, D-97346 Iphofen (DE); EDH, Mikael, S-461 53 Trollhättan (SE)
(74) Representative: Werner, Hans-Karsten
(86) International application number: PCT/SE1999/000859
(87) International publication number: WO 1999/062076

(56) References cited:
- US-A- 4 909 901
- DATABASE WPI Derwent Publications Ltd., London, GB; AN 1987-316616, XP002921524 ASAHI CHEM IND CO LTD: 'Electroconductive filled paper for antistatic materials etc. - contains cellulosic fibres, inorganic fillers, organic polymers and carbon fibres' & JP 62 223 397 A 01 October 1987
- DATABASE WPI Derwent Publications Ltd., London, GB; AN 1998-303948, XP002921525 YOSHINO SEKKO KK: 'Electric wave absorptive plaster board for electronic device installation, building - includes core covered on both sides by original paper containing pulp of electrically conductive pulp' & JP 10 107 478 A 24 April 1998

## Description

The present invention relates to a very thin, electrically conductive layer of cellulose fibres. The layer contains 95-100% of carbon fibres and cellulose fibres calculated on the bone dry weights, the amount of carbon fibres with a diameter of 1-15 microns and a length of 1-20 mm being from 4 to 20% calculated on the bone dry weights and the amount of cellulose fibres from 75-96% calculated on the bone dry weights. The layer has a high electrical conductivity and high electromagnetic shielding capacity combined with superb permeability of water vapour.

It is well-known that an electrical cable under alternating voltage of a low frequency (LF) causes an electric field with radial extension from the cable and magnetic fields with concentric extension from the cable. When the electromagnetic field originates from a high frequency (HF) device, such as a radio, TV, mobile telephone or radar, the electrical and magnetic field merge into a wave. The intensity of electromagnetic fields decrease with the distance from the source. The electrical and/or electromagnetic field can be reduced or eliminated by simple technical measures. For instance, indoor spaces may be shielded against HF by placing electrically conductive materials, such as foils, wire-nettings, webs and fabrics, coated with metal-containing composition and mortars containing carbon fibres, in floors, walls and ceilings. For LF shielding the above mentioned materials as well as graphite containing paints can be used, if they are connected to earth.

In the patent literature, it exists a large number of publications describing various electrically conductive materials having the ability to reduce electromagnetic fields. For instance DE-A-19 543 877 discloses the application of coatings of a thickness of maximum 2 mm of a gypsum mortar, which preferably contains 1.5-3% by weight of carbon fibres. Due to the presence of carbon fibres the mortar exhibits good shielding properties towards electric and electromagnetic fields The Derwent patent abstract 92-224 143 describes a conductive fibre sheet comprising a cellulose pulp and carbon fibres uniformly dispersed into the pulp. The sheet has for example a thickness of 0.5 mm and a surface resistance of 1.5 ohm/cm². The Derwent patent abstract 90-048 000 relates to a vulcanised fibre board prepared by immersing a paper sheet containing conductive fibres, such as carbon fibres into a concentrated aqueous solution of ZnCl₂. The fibre sheet preferably has a thickness of 0.2-3 mm. The Derwent patent abstract 91-290 618 discloses an electromagnetic wave shielding sheet comprising stainless steel fibres, cellulose fibres, polyamide epichlorohydrin resin and polyvinylidene chloride polymer. The Derwent patent abstract 90-227 036 describes a conductive thermoplastic material containing conductive fibre made preferably of glass, nylon or polyester and coated with Cu and Ag in two layers. The Derwent patent abstract 88-047 415 5 discloses an electrically conductive sheet formed from a mixture of metal coated carbon fibres, on which a water-soluble, high molecular polymer has been applied, and other types of fibres.

Derwent patent abstract 87-316616 describes an electro-conducting filled paper containing inorganic filler and organic polymers and has good waterproof strength.

One objective of the present invention is to provide a material, which has a high electric and electromagnetic shielding effect and is easy to produce at low cost. Another objective is to provide a material that is suitable to apply on or combine with other materials without causing any undesired property to the material Still another objective is to obtain a material with high water vapour permeability to secure good ventilation through the material and thereby preventing inclusion of water or allowing it to be used in the production of gypsum board. In this way several process steps, such as mounting, priming, painting or fixing of shielding materials, can be reduced into one step, namely mounting of the plaster board.

Surprisingly, it has been found that all these objectives are met by a material in the form of a thin cellulose layer containing electrically conductive carbon fibres. More precisely the present invention relates to a cellulose layer having a thickness from 30 to 80 microns, preferably from 35 to 70 microns, and a weight of from 20 to, 60 grams /m² and containing 95-100% of carbon fibres and cellulose fibres, calculated on the bone dry weights, the amount of the carbon fibres with a diameter from 1 to 15 microns, preferably from 4 to 10 microns, and a length from 1 to 20 mm, preferably from 2 to 10 mm, being from 4 to 20% by weight, preferably from 8 to 15% by weight, calculated on bone dry weights, and the amount of the cellulose fibres being from 75 to 96% by weight, preferably from 80 to 92% by weight calculated on the bone dry weights. The layer of the invention a surprisingly exhibits high electromagnetic shielding effect and low electrical resistance with regard to the amount of carbon fibres per unit of layer area. In addition hereto the layer has a very high permeability of water vapour. These properties probably depend on the dimensions of the carbon fibres and the small thickness of the layer.

The layer can easily be produced in an ordinary paper machine by first preparing a stock by mixing cellulose fibres and carbon fibres in desired amounts in water. The cellulose fibres suitably used in the manufacture of the layer may be derived from any conventional cellulose pulps, such as chemical pulps, chemi-mechanical pulps and mechanical pulps. Recycled cellulose fibres are also suitable for use. Preferably, at least 90% by weight of the cellulose fibres have a diameter and a length within the same ranges as the carbon fibres. Besides the cellulose and carbon fibres, normal paper processing additives, such as water retention agents, sizing agents, dispersing agents, drainage aids, flocculants, defoamers and pigments may be added to the pulp. There is usually no need to add any dry strength agents, since the amount of hemicellulose and resin present in the pulp is sufficient to bind the fibres in the layer together. The stock ready for use has suitably a bone dry content from 0.1 to 5% by weight of the pulp and preferably 0.1 to 0.5% of the pulp when de-watering on a foudrinier wire. The stock is then suitably de-watered in a conventionally manner on a foudrinier wire or cylinder mould and the paper web formed is dried and, if desired, calendered to a layer, which may be winded up on a roll.

In one embodiment of the invention the above described cellulose layer is incorporated into a paper board and thereby obtaining an electrically conductive paper board. Such a paper board can be manufactured in a paper board machine by one or more of the co-ordinated formation units producing cellulose layers according to the invention. Conventional cellulose plies are manufactured in the remaining formation units, whereupon these plies are combined to an electrically conductive paperboard having a high electrical and electromagnetic shielding capacity. This paperboard as well as a single layer can easily be incorporated into products, such as conventional floor materials and wall and ceiling products, including linoleum, gypsum boards and concrete boards.

Paper boards containing at least one layer according to the invention are very suitable to use as a liner in the production of gypsum boards. A continuos liner is used as a platform and mould for the gypsum hemihydrate water slurry, which also may contain starch in amounts from 0.05 to 0.5% by weight calculated on the weight of gypsum hemihydrate. After adding the slurry a second continuos liner is immediately applied on top of the gypsum slurry. Any of the two liners or both contain an electrically conductive layer of the invention. Suitably the liners exhibit a conventional cellulose ply nearest to the gypsum slurry. Shortly after the water contact, the gypsum starts to solidify and simultaneously bonds are created between gypsum and the liners. It has surprisingly been found that liners with an electrically conductive layer according to the invention exhibit excellent water permeability and allow evaporation in a conventional gypsum board drying operation of the large excess of water present in a gypsum water slurry without disrupting the liners and the fragile bonds between the liners and gypsum. The wet and dry strength of the gypsum board is essentially unaffected by the presence of the layer containing carbon fibres. In general, about 3-5 kg of excess water per m² of liner has to be evaporated during approx. 20 minutes with a peak evaporation of about 10 to 20 litres of steam per m² of liner and second. Although the amount of electrically conductive carbon fibres per m² of the gypsum board is low the shielding effect is essential.

The present invention is further illustrated by the following Examples.

### Example 1

The effect of a gypsum board, containing a paper board having an electrically conductive layer according to the invention, on the electrical field caused by a three wire in-house cable under 230 V of 50 Hz was measured. The gypsum board had on one side a paper board consisting of four cellulose plies and one electrically layer of the invention. The electrically conductive layer had a thickness of 65 microns and contained 10% by weight of carbon fibres and 90% by weight of recycled cellulose fibres. The diameter and the length of the carbon fibres were 7-9 microns and 4-10 mm, respectively, and of the cellulose 2-5 microns and 1-3 mm. In addition to the layer, the paper board also contained 4 layers manufactured from recycled cellulose fibres of the same type as used in the electrically conductive layer.

Gypsum boards (12 mm thick) as described above (invention) or conventional gypsum boards (contral) were mounted onto wood-frames and placed with the fibre direction vertically onto a concrete floor. The gypsum boards were either earthed or unearthed. The electrical fields were determined at different distances from the gypsum board with a measuring device , FM 6E from Fauser Electrotechnik in Germany, connected to earth and placed on the front and with the electrical cable on the back.

The following results were obtained.

| | Electrical field V/m | | | | | |
|---|---|---|---|---|---|---|
| Distance, cm | 5 | 10 | 20 | 30 | 40 | 50 |
| No board | 237 | 142 | 100 | 75 | 62 | 53 |
| Gypsum board (control) | | | | | | |
| -unearthed | 153 | 108 | 82 | 64 | 53 | 42 |
| -earthed | 151 | 107 | 81 | 64 | 53 | 42 |
| Board in wood-frame | | | | | | |
| -unearthed | 77 | 58 | 42 | 33 | 26 | 21 |
| -earthed | 0 | 0 | 0 | 0 | 0 | 0 |

From the result it is evident that gypsum board according to the invention has a good electric shielding effect at alternating electrical currents of 50 Hz.

### Example 2

The resistance of different materials were measured in the following way. Two squares of 10 x 10 cm was marked on a conventional paper board (Control) and on a paper board with a outer electrically conductive layer according to the invention (Invention). On two opposite sides of the squares liquid silver was painted in the width of 4 mm. In one square the silver lines were perpendicular to the fibre direction and in the other parallel to the fibre direction of the board. The liquid silver provides a superb electrical conductor over the entire width of the tested material. The resistance of the materials were measured between diagonal points of the two silver lines.

The following results were obtained.

| Material | Resistance in kOhm/² |
|---|---|
| Control | |
| - parallel | >40 000 |
| - vertical | >40 000 |
| Invention | |
| -parallel | 0.03 |
| -vertical | 0.05 |

From the results it is evident that the electrical conductivity of a paper board according the invention is much higher than for a conventional paper board.

### Example 3

The ability of different materials to shield high frequency electromagnetic fields was measured in the following way. The materials to be tested were placed according to MIL-standard 285 between a transmitter antenna and a receiver antenna. The transmitted frequency was polarised and scanned from 1 GHZ to 10 GHZ. The materials tested were an electromagnetic compatibility wallboard from Marburger Tapetenfabrik, Germany; a latex paint with graphite powder from Biologa, Germany; a conventional paper board; paper boards according to the invention, one containing a layer with 10% by weight of carbon fibres and one containing two layers with the fibre directions in right angle; and a prefabricated wall containing from the outside to the inside a 6 mm plaster board + 30 mm wood chip board + 100 mm mineral wool +polyethylene folio + 9 mm plaster board with a conventional liner or a liner containing a layer with 10% by weight of carbon fibres according to the invention.

The following results were obtained.

| Materials tested | -dB shielding¹⁾ at | | | |
|---|---|---|---|---|
| | 1 GHZ | 2 GHZ | 6 GHZ | 10 GHZ |
| Conventional paper board | 0 | 0 | 0 | 0 |
| Paper board (invention) | | | | |
| -parallel to polarisation | 13 | 16 | 13 | 16 |
| -vertical to polarisation | 9 | 10 | 9 | 11 |
| -two layers | 17 | 21 | 19 | 16 |
| Shielding wall-paper | 9 | 7 | 8 | 9 |
| Shielding paint | 0 | 0 | 0 | 0 |
| Prefabricated wall | | | | |
| -with liner of invention | 18 | 25 | 23 | 16 |
| -with conventional liner | 2 | 4 | 3 | 4 |
| 1)= capacity of instrument | >27 | >27 | 23 | 16 |

The results shows that the materials containing a layer in accordance with the invention have a high frequency shielding ability which is essentially higher than in the conventional materials in the comparison. The layer of the invention is also more versatile, since it easily can be integrated in a number of products.

## Claims

1. An electrically conductive cellulose layer having the ability to shield electric and high frequency fields, **characterised in that** it has a thickness from 30 to 80 microns and a weight of from 20 to 60 grams/m² and contains 95-100% of carbon fibres and cellulose fibres, calculated on the bone dry weights, the amount of the carbon fibres with a diameter from 1 to 15 microns and a length from 1 to 20 mm being from 4 to 20% by weight, calculated on bone dry weights, and the amount of the cellulose fibres being from 75 to 96% by weight, calculated on the bone dry weights.

2. Cellulose layer according claim 1, **characterised in that** the layer has a thickness from 35 to 70 microns, the amounts of carbon fibres with a diameter from 4 to 10 microns and a length from 2 to 10 mm are from 8 to 15% by weight, calculated on bone dry weights, and the amount of the cellulose fibres is from 80 to 92% by weight, calculated on the bone dry weights.

3. Cellulose layer according to any one of claims 1-2, **characterised in that** the cellulose fibres are derived from recycled cellulose fibres.

4. An electrically conductive paper board having the ability to shield electric and high frequency fields, **characterised in that** it contains an electrically conductive layer according to any one of claims 1-3.

5. An electrically conductive building material having the ability to shield electric and high frequency fields, **characterised in that** it contains a layer according to any one of claims 1-3 or a paper board according to claim 4

6. An electrically conductive gypsum board having the ability to shield electric and high frequency fields, **characterised in that** it contains an electrically conductive paper board according to claim 4 as a liner.

## Patentansprüche

1. Elektrisch leitfähige Celluloseschicht mit der Fähigkeit, elektrische und hochfrequente Felder abzuschirmen, **dadurch gekennzeichnet, dass** sie eine Dicke von 30 bis 80 µm und ein Gewicht von 20 bis 60 g/m² hat und 95-100% Kohlenstofffasern und Cellulosefasern enthält, berechnet auf der Basis der absoluten Trockengewichte, wobei die Menge der Kohlenstofffasern mit einem Durchmesser von 1 bis 15 µm und einer Länge von 1 bis 20 mm 4 bis 20 Gew.-% beträgt, berechnet auf der Basis der absoluten Trockengewichte, und die Menge der Cellulosefasern 75 bis 96 Gew.-% beträgt, berechnet auf der Basis der absoluten Trockengewichte.

2. Celluloseschicht gemäß Anspruch 1, **dadurch gekennzeichnet, dass** die Schicht eine Dicke von 35 bis 70 µm hat, wobei die Menge der Kohlenstofffasern mit einem Durchmesser von 4 bis 10 µm und einer Länge von 2 bis 10 mm 8 bis 15 Gew.-% beträgt, berechnet auf der Basis der absoluten Trockengewichte, und die Menge der Cellulosefasern 80 bis 92 Gew.-% beträgt, berechnet auf der Basis der absoluten Trockengewichte.

3. Celluloseschicht gemäß einem der Ansprüche 1 bis 2, **dadurch gekennzeichnet, dass** die Cellulosefasern von recycelten Cellulosefasern stammen.

4. Elektrisch leitfähige Pappe mit der Fähigkeit, elektrische und hochfrequente Felder abzuschirmen, **dadurch gekennzeichnet, dass** er eine elektrisch leitfähige Schicht gemäß einem der Ansprüche 1 bis 3 enthält.

5. Elektrisch leitfähiges Baumaterial mit der Fähigkeit, elektrische und hochfrequente Felder abzuschirmen, **dadurch gekennzeichnet, dass** es eine Schicht gemäß einem der Ansprüche 1 bis 3 oder eine Pappe gemäß Anspruch 4 enthält.

6. Elektrisch leitfähige Gipsplatte mit der Fähigkeit, elektrische und hochfrequente Felder abzuschirmen, **dadurch gekennzeichnet, dass** sie eine elektrisch leitfähige Pappe gemäß Anspruch 4 als Verkleidung enthält.

## Revendications

1. Couche de cellulose électriquement conductrice présentant une capacité de blindage vis-à-vis des champs électriques et des champs à haute fréquence, **caractérisée en ce qu'**elle a une épaisseur allant de 30 à 80 microns et un poids allant de 20 à 60 grammes/m² et contient 95 à 100% de fibres de carbone et de fibres de cellulose, calculé sur les poids à l'état sec, la quantité de fibres de carbone ayant un diamètre de 1 à 15 microns et une longueur de 1 à 20 mm étant de 4 à 20% en poids, calculée sur les poids à l'état sec, et la quantité de fibres de cellulose étant de 75 à 96% en poids, calculée sur les poids à l'état sec.

2. Couche de cellulose selon la revendication 1, **caractérisée en ce que** la couche a une épaisseur de 35 à 70 microns, les quantités de fibres de carbone ayant un diamètre de 4 à 10 microns et une longueur de 2 à 10 mm sont de 8 à 15% en poids, calculées sur les poids à l'état sec, et la quantité des fibres de cellulose est de 80 à 92% en poids, calculée sur les poids à l'état sec.

3. Couche de cellulose selon l'une quelconque des revendications 1 à 2, **caractérisée en ce que** les fibres de cellulose sont proviennent de fibres de cellulose recyclées.

4. Carton électriquement conducteur présentant une capacité de blindage vis-à-vis des champs électriques et des champs à haute fréquence, **caractérisé en ce qu'**il contient une couche électriquement conductrice selon l'une quelconque des revendications 1 à 3.

5. Matériau de construction électriquement conducteur présentant une capacité de blindage vis-à-vis des champs électriques et des champs à haute fréquence, **caractérisé en ce qu'**il contient une couche selon l'une quelconque des revendications 1 à 3 ou un carton selon la revendication 4.

6. Panneau de plâtre électriquement conducteur présentant une capacité de blindage vis-à-vis des champs électriques et des champs à haute fréquence, **caractérisé en ce qu'**il contient comme garniture un carton électriquement conducteur selon la revendication 4.
